**Europäisches Patentamt**

**European Patent Office**

**Office européen des brevets**

(19)

(11) **EP 1 484 910 A1**

(12) **DEMANDE DE BREVET EUROPEEN**

(43) Date de publication:
**08.12.2004 Bulletin 2004/50**

(51) Int Cl.⁷: **H04N 5/235**, H04N 5/335, **H03M 1/18**

(21) Numéro de dépôt: **03012594.2**

(22) Date de dépôt: **03.06.2003**

(84) Etats contractants désignés:
**AT BE BG CH CY CZ DE DK EE ES FI FR GB GR HU IE IT LI LU MC NL PT RO SE SI SK TR**
Etats d'extension désignés:
**AL LT LV MK**

(71) Demandeur: **ASULAB S.A.**
**2074 Marin (CH)**

(72) Inventeurs:
• **Aeby, Fabien**
**1580 Avenches (CH)**

• **Genilloud, Laurent**
**1680 Romont (CH)**

(74) Mandataire: **Laurent, Jean et al**
**I C B**
**Ingénieurs Conseils en Brevets SA**
**Rue des Sors 7**
**2074 Marin (CH)**

(54) **Dispositif et procédé de conversion analogique numérique surnuméraire adaptatif pour un capteur d'image**

(57)    Le dispositif de conversion analogique-numérique surnuméraire (1) pour un capteur d'image comprend au moins un premier convertisseur grossier non linéaire à N bits (21) recevant un signal de tension d'un pixel (Vpix), et au moins un second convertisseur fin linéaire à M bits (22) connecté au premier convertisseur (21) afin que le dispositif fournisse un mot binaire à N+M bits relatif au niveau de tension du pixel. Le premier convertisseur (21) comprend des moyens de comparaison (33) pour comparer le niveau de tension du pixel avec un ou plusieurs seuils de tension (V0 à V4) délimitant des plages de tension dans la gamme dynamique de tension du capteur. Les plages successives de tension représentent des zones d'illumination du pixel entre une zone faiblement éclairée et une zone fortement éclairée. Le premier convertisseur fournit un mot binaire à N bits relatif à la zone déterminée d'illumination du pixel. Le second convertisseur comprend des moyens d'adaptation de conversion pour convertir le signal de tension du pixel sur un nombre de bits inférieur ou égal à M dépendant du mot binaire à N bits du premier convertisseur.

Fig.4

**EP 1 484 910 A1**

## Description

L'invention concerne un dispositif de conversion analogique numérique de type surnuméraire adaptatif. De préférence, le dispositif de conversion permet de convertir numériquement des signaux produits par une cellule photosensible d'un capteur d'image. La cellule photosensible est composée d'une matrice de pixels.

Le dispositif de conversion comprend donc au moins un premier convertisseur à N bits recevant un signal de tension ou de courant d'un pixel, et au moins un second convertisseur à M bits connecté au premier convertisseur, les premier et second convertisseurs permettant de convertir le niveau de tension ou de courant du pixel sur N+M bits. Le niveau de tension ou de courant du signal produit par chaque pixel est dépendant de la lumière captée dans une gamme dynamique déterminée de tension ou de courant du capteur.

Une conversion surnuméraire signifie qu'il est opéré une conversion avec un nombre de bits plus important que le nombre de bits conservés de chaque pixel après l'opération de conversion. De cette manière, il est possible d'opérer une amplification numérique en fonction du niveau d'illumination des pixels.

L'invention concerne également un capteur d'image comprenant notamment la cellule photosensible à matrice de pixels, le dispositif de conversion analogique-numérique relié à la cellule, un moyenneur d'illumination relié au dispositif de conversion et un adaptateur d'échelle relié au dispositif de conversion et au moyenneur.

L'invention concerne également un procédé de conversion analogique numérique pour la mise en action du dispositif de conversion analogique-numérique.

Pour capter une image, une cellule photosensible comprend généralement une matrice de pixels afin de fournir chacun des signaux convertis par exemple en tension représentant le nombre de photons captés. Plus ce nombre de photons est important et plus l'écart de tension produit est important. Habituellement, une image numérique est quantifiée sur 8 bits, soit 256 niveaux possibles. Dans le cas d'une image couleur, chaque composante primaire (rouge, verte, bleue) est codée sur 8 bits.

A ce titre, il est utile de rappeler que chaque pixel comprend une capacité à jonction, telle qu'une photodiode, pour capter des photons, notamment avec un puits de 100'000 électrons. En fonctionnement normal, cette capacité ou photodiode est inversement polarisée à une tension donnée par exemple entre 0 et 2 V.

Dans un capteur d'image du type APS (Active-Pixel Sensor en terminologie anglaise) réalisé dans une technologie CMOS, les photons déchargent une capacité en générant des paires électron-trou. Ces paires électron-trou sont collectées par les électrodes opposées de la capacité et par conséquent réduisent l'écart de tension aux bornes de la capacité. Comme cet écart de tension décroît avec l'illumination, il est prévu d'inverser la polarité du signal de manière à avoir une tension importante quand l'illumination du pixel est importante et une tension faible en cas de faible illumination. Ainsi, la gamme dynamique de tension du capteur est inférieure à la tension de polarisation de la capacité, par exemple égale à 1,5 V. Cette condition n'est cependant pas limitative.

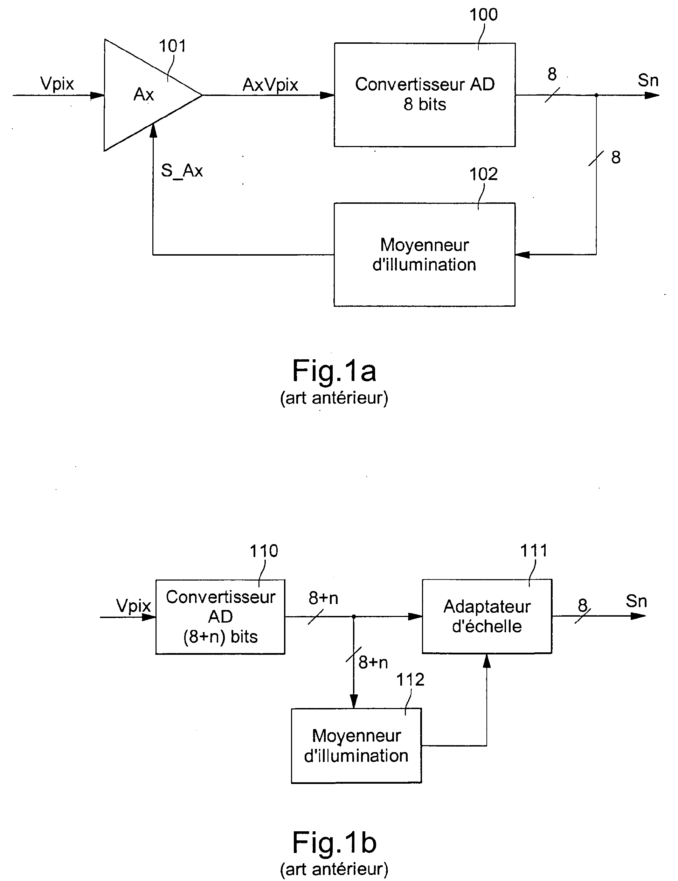

Lors de la conversion des signaux de tension produits par les pixels, une amplification de ces signaux doit en général être effectuée. Cette amplification est dépendante du niveau de l'illumination des pixels de l'image captée. Pour réaliser cette amplification des signaux, il peut être prévu d'opérer par exemple une pré-amplification de chaque signal des pixels avant l'opération de conversion analogique-numérique comme montré schématiquement à la figure 1a. Pour ce faire dans le capteur d'image, un certain nombre d'amplificateurs à gain variable 101 sont par exemple connectés chacun en sortie d'un pixel respectif non représenté pour recevoir une tension convertie Vpix correspondant à l'illumination captée. L'amplificateur à gain variable 101 pour chaque pixel amplifie la tension sensiblement constante Vpix par un facteur d'amplification Ax afin de fournir en sortie un signal de tension amplifié AxVpix. Le signal amplifié est ensuite converti numériquement dans un convertisseur AD standard à 8 bits 100 pour produire un mot binaire à 8 bits Sn.

Le facteur d'amplification Ax des amplificateurs est ajusté à la gamme dynamique du convertisseur après avoir effectué une moyenne de niveaux d'illumination notamment de certains pixels. Cette moyenne est effectuée à l'aide d'un moyenneur d'illumination 102 relié dans une boucle de contre-réaction entre le convertisseur 100 et le ou les amplificateurs 101. Un signal de commande S_Ax est fourni par le moyenneur à l'amplificateur pour ajuster ce facteur d'amplification.

Pour fixer ce facteur d'amplification, il est nécessaire d'effectuer plusieurs conversions analogiques-numériques afin d'atteindre un état optimal de la moyenne d'illumination de l'image captée par les pixels ce qui est un inconvénient. Un autre inconvénient avec une amplification analogique de la tension de chaque pixel est que cela engendre une forte consommation d'énergie due notamment à un surplus de travail du capteur d'image. Ceci rend donc difficile une utilisation d'un tel capteur dans un objet portable, tel qu'une montre-bracelet, qui est alimenté par des piles ou des accumulateurs de petite taille. De plus, il est difficile de paralléliser plusieurs amplificateurs analogiques appariés dans une même structure semi-conductrice pour gagner du temps de conversion d'une image captée par la matrice de pixels.

Une autre solution pour amplifier les signaux des pixels consiste à opérer une amplification numérique à l'aide d'un convertisseur analogique-numérique du type surnuméraire d'un capteur d'image comme représenté schématiquement à la figure 1 b. Pour cette amplification numérique, la tension convertie Vpix par chaque pixel est tout d'abord numérisée à l'aide d'un dispositif de conversion ou convertisseur AD surnuméraire à 8+n bits 110. Le mot binaire produit par le convertisseur 110 est fourni à un adaptateur d'échelle 111 qui est chargé de prélever les mêmes 8 bits successifs de chaque mot binaire à 8+n bits et de fournir un signal binaire Sn à 8 bits. Le choix des 8 bits successifs prélevés de chaque mot binaire est dépendant d'une moyenne d'illumination d'un sous-ensemble de pixels de la matrice ayant captée une image à numériser. Cette moyenne d'illumination est réalisée par un moyenneur d'illumination 112. Ce moyenneur d'illumination 112 fait par exemple une moyenne sur plusieurs mots binaires à 8+n bits du convertisseur 110 afin de déterminer quels sont les bits les plus représentatifs des signaux de tension Vpix numérisés.

Ainsi avec cette amplification numérique, il est possible de différer la prise de décision concernant le niveau d'illumination moyen de l'image captée par la matrice de pixels, ce qui évite un contrôle d'exposition préalable comme c'est le cas avec une amplification analogique. Cependant avec un tel dispositif de conversion 110 standard, une conversion à 8+n bits est effectuée dans tous les cas d'illumination des pixels, ce qui peut être un inconvénient. Cette conversion avec ce surplus de précision n'est pas toujours nécessaire notamment lors d'une forte illumination des pixels de la cellule photosensible, car le bruit du capteur d'image provenant de la cellule photosensible est plus important en forte illumination qu'en faible illumination. Il se peut donc que, lors de la détermination des bits de poids faibles d'un pixel fortement illuminé, le convertisseur convertisse des niveaux de tension ou de courant plus faibles que le bruit du pixel. Ceci rend cette opération superflue, puisque aléatoire, ce qui est un inconvénient.

L'invention a donc pour but principal de pallier les inconvénients de l'art antérieur en fournissant un dispositif de conversion analogique-numérique surnuméraire qui peut être adapté selon le niveau d'illumination de chaque pixel de la cellule photosensible. Le dispositif de conversion est par exemple adapté de manière à ne pas convertir inutilement du bruit lors d'une prise d'image par la cellule photosensible.

A cet effet, l'invention a pour objet un dispositif de conversion analogique-numérique cité ci-devant qui se caractérise en ce que le premier convertisseur comprend des moyens de comparaison pour comparer le niveau de tension ou de courant du pixel avec un ou plusieurs seuils de tension ou de courant délimitant des plages de tension ou de courant dans la gamme dynamique déterminée, lesdites plages successives de tension ou de courant pouvant représenter des zones d'illumination du pixel entre une zone faiblement éclairée et une zone fortement éclairée, ledit premier convertisseur fournissant un mot binaire à N bits relatif à la zone déterminée d'illumination du pixel, et en ce que le second convertisseur comprend des moyens d'adaptation de conversion pour convertir le signal de tension ou de courant du pixel sur un nombre de bits inférieur ou égal à M dépendant du mot binaire à N bits du premier convertisseur.

Un avantage du dispositif de conversion analogique-numérique, selon l'invention, réside dans le fait que les moyens d'adaptation du second convertisseur permettent de ne convertir que le signal utile fourni par chaque pixel en évitant de convertir inutilement du bruit lors de la prise d'image par la cellule photosensible. Le second convertisseur est adapté en fonction du mot binaire produit par le premier convertisseur pour opérer une conversion sans surplus de précision. Ce mot binaire fourni par le premier convertisseur est dépendant du niveau de tension ou de courant de chaque pixel afin de déterminer la zone d'illumination de chaque pixel. De ce fait, cela permet de diminuer la consommation d'énergie notamment du dispositif lors des étapes de conversion de chaque signal de tension ou de courant fourni par les pixels.

De préférence, comme le bruit en forte illumination est approximativement 8 fois plus important qu'en faible illumination, les pixels faiblement éclairés doivent être plus finement convertis que les pixels moyennement ou fortement éclairés. Il est donc défini des plages de tension de taille différente dans la gamme dynamique représentant chacune une zone d'illumination déterminée en fonction de la différence de bruit. Ceci permet d'opérer une amplification numérique par exemple 8 fois plus importante des signaux des pixels faiblement éclairés que ceux fortement éclairés.

Dans le cas d'une prise d'image par une cellule photosensible d'un capteur d'image du type APS CMOS, le bruit est proche de 1 mV à faible illumination, alors qu'il peut valoir près de 8 mV à forte illumination. Pour éviter que la sortie finale à 8 bits ne contiennent des bits de bruit, il faut prévoir une amplification numérique d'un facteur 8 correspondant à 3 bits supplémentaires. Dans ce cas de conversion linéaire à 11 bits (N+M+1 bits), la résolution du dernier bit de poids faible est constante sur toute la gamme dynamique et est rapidement noyée dans le bruit. Lorsque le pixel se trouve dans une zone à forte illumination, les trois derniers bits de poids faible ne contiennent plus d'information et leur traitement est donc inutile.

Il est possible de réduire le nombre de bits à convertir en dé-linéarisant le premier convertisseur à N bits. En sachant que le second convertisseur traite jusqu'à M bits de manière linéaire (à gain constant), on fixe la taille de la zone de faible illumination afin que la précision du dernier bit de poids faible soit équivalente à un convertisseur linéaire standard à N+M+1 bits sur toute la gamme dynamique. Par contre en cas de forte illumination, le dernier bit converti doit être 8 fois moins sensible que le dernier bit en faible illumination. Le second convertisseur ne convertit donc que sur un nombre de bits inférieur à M afin de gagner également du temps de conversion et de réduire la consommation d'énergie électrique.

Il faut donc un facteur 2 supplémentaire entre le gain de conversion à faible illumination et celui en forte illumination. Par conséquent, les zones de forte illumination sont deux fois plus étendues que celle de faible illumination.

Pour les cas intermédiaires, une zone de taille légèrement supérieure à la zone de faible illumination est convenable.

L'invention a également pour objet un capteur d'image, qui comprend les caractéristiques mentionnées dans la revendication 9.

Un avantage d'un tel capteur d'image, selon l'invention, réside dans le fait qu'en diminuant le temps de conversion avec un dispositif de conversion ayant plusieurs premier et second convertisseurs placés en parallèle de structures lentes et bien optimisées, la consommation électrique peut être fortement réduite. Toutefois en parallélisant plusieurs dizaines de premier et second convertisseurs, la technologie CMOS actuelle pour la réalisation de tels circuits intégrés, ne permet pas de réaliser des convertisseurs de plus de 10 bits en conservant une taille raisonnable. De ce fait, il est nécessaire pour des pixels faiblement éclairés d'opérer une conversion fine dans la première plage de tension par le second convertisseur avec une précision de conversion qui correspond à celle d'un convertisseur linéaire à 11 bits standard sur toute la gamme dynamique de tension du capteur.

L'invention a également pour objet un procédé de conversion analogique-numérique, qui comprend les caractéristiques mentionnées dans la revendication 11.

Les buts, avantages et caractéristiques du dispositif de conversion analogique-numérique, ainsi que le capteur d'image et le procédé de mise en action du dispositif apparaîtront mieux dans la description suivante de modes de réalisation de l'invention en liaison avec les dessins dans lesquels :

La figure 1a déjà citée représente schématiquement une partie de conversion analogique-numérique d'un capteur d'image avec une amplification analogique à gain variable de la tension fournie par chaque pixel selon l'art antérieur;

la figure 1b déjà citée représente schématiquement une partie de conversion analogique-numérique d'un capteur d'image avec une amplification numérique après la phase de conversion selon l'art antérieur;

la figure 2 représente schématiquement un ensemble de prise d'image destiné à équiper un objet portable, tel qu'une montre-bracelet, qui comprend un dispositif de conversion analogique-numérique surnuméraire adaptatif selon l'invention;

la figure 3 représente un graphique de la tension efficace de bruit en fonction du potentiel de la gamme dynamique du capteur d'image;

la figure 4 représente schématiquement le dispositif de conversion analogique-numérique avec les premier et second convertisseurs selon l'invention;

la figure 5 représente de manière plus détaillée le dispositif de conversion analogique-numérique avec des composants combinés pour les premier et second convertisseurs;

la figure 6 représente une partie du second convertisseur, qui comprend un réseau de capacités commutables pondérées en puissance de 2 et le circuit de commutation;

les figures 7a et 7b représentent d'une part un graphique de la fonction de transfert du premier convertisseur, définissant les zones d'illumination en fonction des seuils de tension de la gamme dynamique de tension, et d'autre part un registre pour chaque mot binaire à 10 bits fourni après les opérations de conversion des premier et second convertisseurs, et

la figure 8 représente des étapes (algorithme) du procédé de conversion analogique-numérique dans un dispositif de conversion selon l'invention.

Dans la description suivante, tous les composants électroniques du dispositif de conversion analogique-numérique surnuméraire, ainsi que les étapes de conversion, qui sont bien connus d'un homme du métier dans ce domaine technique, ne seront pas expliqués en détail.

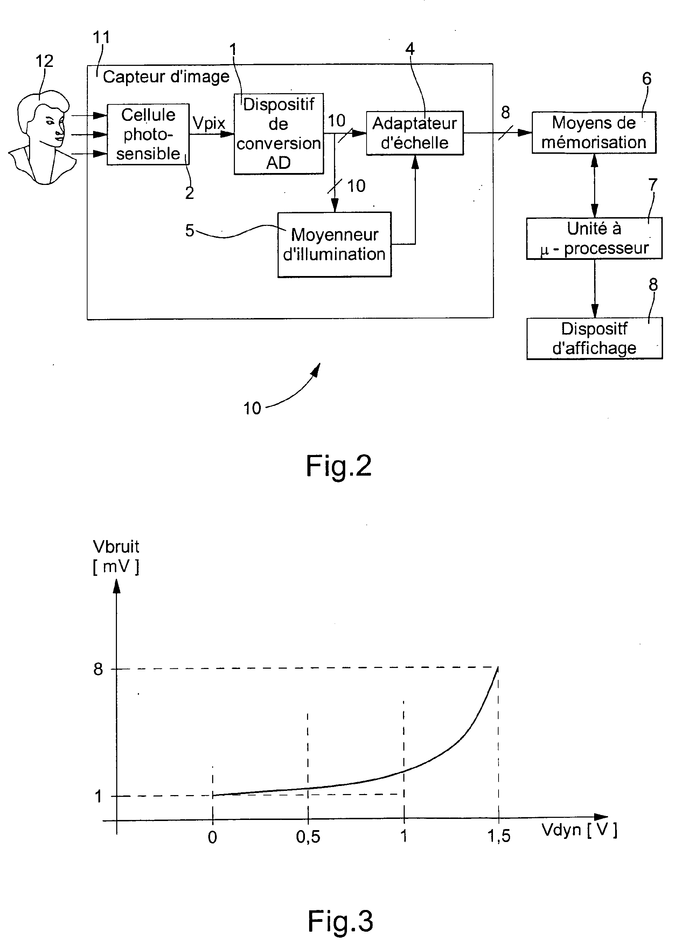

A la figure 2, un ensemble de prise d'image 10, notamment du type APS, est représenté dans lequel est disposé un dispositif de conversion analogique-numérique surnuméraire 1 selon l'invention. L'ensemble comprend essentiellement un capteur d'image 11, qui est composé d'une cellule photosensible à matrice de pixels 2 pour capter une image 12, le dispositif de conversion analogique-numérique 1 des signaux fournis par les pixels du capteur, un moyenneur d'illumination 5, un adaptateur d'échelle 4, des moyens de mémorisation de l'image numérisée 6, une unité à microprocesseur 7 et un dispositif d'affichage de l'image captée 8. La matrice de pixels d'un capteur d'image APS VGA (Video Graphics Array en terminologie anglaise) est composée par exemple de 640 par 480 pixels fonctionnant dans une gamme dynamique d'approximativement 1,5 V.

Le dispositif de conversion 1, objet de l'invention, fournit des mots binaires à 10 bits relatifs à la conversion de signaux de tension produits par des pixels de la cellule 2. Ces mots binaires peuvent être mémorisés après les opérations de conversion successives ou en parallèle chacun dans des registres correspondants non représentés du dispositif 1. Le moyenneur d'illumination 5 reçoit donc un certain nombre de mots binaires à 10 bits provenant par exemple des registres du dispositif afin de déterminer une moyenne d'illumination desdits mots binaires.

En fonction du résultat de la moyenne opérée dans le moyenneur d'illumination 5, l'adaptateur d'échelle 4 reçoit un signal de commande du moyenneur 5. Ainsi, l'adaptateur configuré par le moyenneur 5 sélectionne 8 bits successifs les plus représentatifs parmi les 10 bits de chaque mot binaire produit par le dispositif de conversion analogique-numérique 1, en fonction du niveau d'illumination moyen de l'image captée. Pour une forte illumination d'une image captée par les pixels de la cellule photosensible 2, il n'est conservé que les 8 bits de poids fort de chaque mot binaire, alors que pour une faible illumination, il n'est conservé que les 8 bits de poids faible.

Tous les signaux de tension ou de courant des pixels numérisés sur 8 bits sont par la suite mémorisés dans des moyens de mémorisation 6, tels qu'une mémoire non volatile de type EEPROM, sous la commande de l'unité à microprocesseur 7. L'unité à microprocesseur 7 exécute de manière connue des calculs spécifiques pour mémoriser dans les moyens de mémorisation 6 tous les octets de la matrice de pixels selon un format déterminé. Ce format peut être par exemple le format JPEG (Joint Photographic Experts Group en terminologie anglaise). L'image ainsi mémorisée peut être visionnée sur le dispositif d'affichage 8 qui peut être un écran LCD couleur.

Comme le bruit produit notamment par la cellule photosensible du capteur n'est pas constant sur toute la gamme dynamique de tension du capteur, le dispositif de conversion analogique-numérique doit être configuré pour tenir compte de la différence de bruit entre une faible illumination et une forte illumination des pixels. La figure 3 représente un graphique montrant la variation du bruit en fonction du niveau de tension produit par chaque pixel dans la gamme dynamique de tension du capteur en fonction du niveau d'illumination des pixels. Pour un capteur d'image du type APS VGA réalisé en technologie CMOS, on remarque que le bruit à faible illumination, proche de la valeur de tension basse de la gamme dynamique, vaut environ 1 mV, alors que le bruit à forte illumination, proche de la valeur de tension haute de la gamme dynamique, vaut environ 8 mV. De ce fait, le dispositif de conversion doit pouvoir convertir plus finement des pixels faiblement éclairés que des pixels plus fortement éclairés par une amplification numérique adaptée. L'amplification de conversion des pixels faiblement éclairés du dispositif doit donc être 8 fois plus importante dans une zone faiblement éclairée des pixels que dans une zone fortement éclairée.

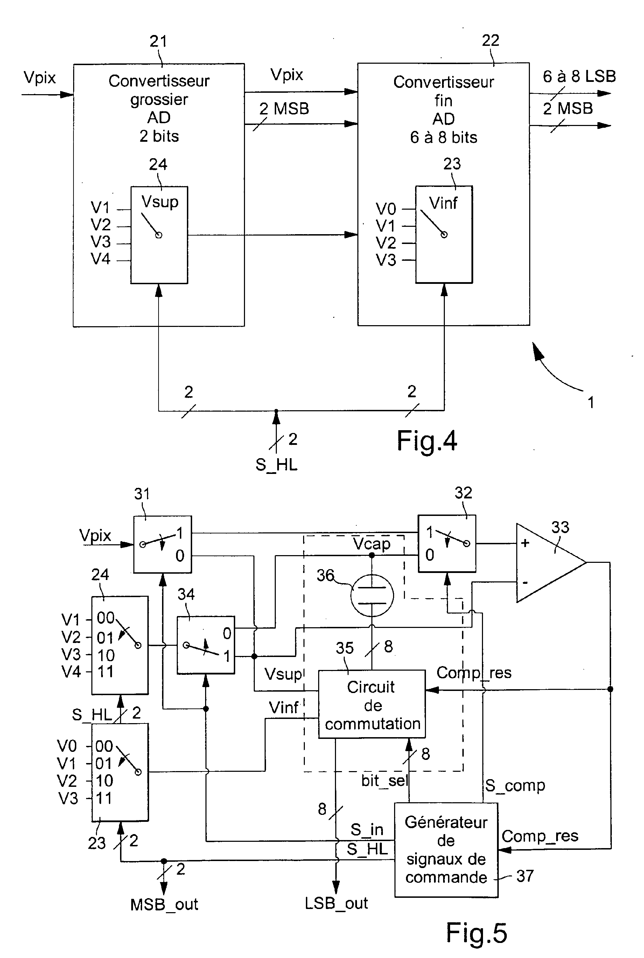

Le dispositif de conversion analogique-numérique surnuméraire, objet de l'invention, est représenté de manière schématique à la figure 4. Ce dispositif comprend essentiellement au moins un premier convertisseur grossier non linéaire 21 et au moins un second convertisseur fin linéaire 22 pour convertir un signal de tension Vpix fourni par un pixel. Le premier convertisseur 21 fournit un mot binaire à N bits de poids fort, par exemple 2 bits, alors que le second convertisseur fournit un mot binaire à M bits de poids faible, par exemple 8 bits. De cette manière, le dispositif fournit un mot binaire à N+M bits, par exemple 10 bits correspondant au signal de tension converti Vpix de chaque pixel.

Dans une première étape de conversion, le premier convertisseur 21 reçoit la tension convertie Vpix de chaque pixel. Ce premier convertisseur 21 a pour tâche de situer le niveau de tension du pixel dans une des plages de tension déterminées de la gamme dynamique de tension du capteur d'image. Cette gamme dynamique est divisée donc en plusieurs plages de tension successives délimitées entre les valeurs inférieure V0 et supérieure V4 de tension de la gamme dynamique par des seuils de tension V1 à V3. Etant donné que dans ce mode de réalisation il est prévu trois seuils de tension, quatre plages de tension définissent chacune une zone particulière d'illumination de chaque pixel entre une zone faiblement éclairée et une zone fortement éclairée.

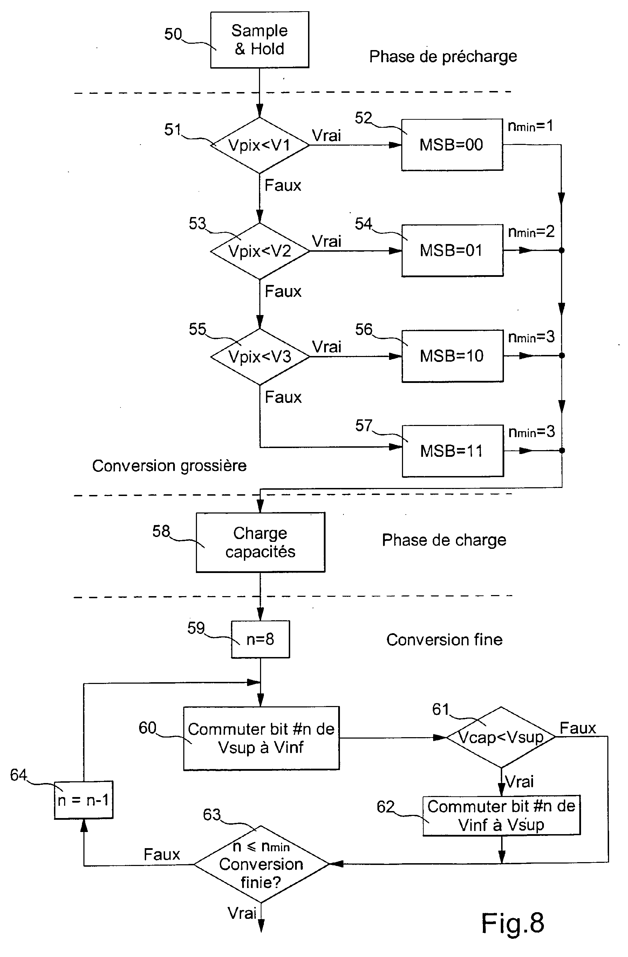

Le premier convertisseur comprend des moyens de comparaison non représentés pour comparer le niveau de tension du pixel avec des seuils de tension V1 à V3 fournis successivement par un multiplexeur 24 de tension supérieure de référence Vsup de manière à déterminer la plage de tension de chaque pixel. Pour ce faire, le multiplexeur 24, qui reçoit en entrée les trois seuils de tension V1 à V3, ainsi que la tension haute de la gamme dynamique V4, est commandé par un signal de commande S_HL à 2 bits. Ce signal de commande peut être incrémenté d'une première valeur binaire égale à 00 à une quatrième valeur binaire égale à 11, comme il sera expliqué ci-après en référence à la figure 8. Avec la première valeur du signal de commande S_HL, le premier seuil de tension V1 est comparé à la tension Vpix. Si cette tension Vpix est supérieure au premier seuil de tension V1, le signal de commande est incrémenté d'une unité afin de comparer le second seuil de tension V2 avec la tension Vpix. Si cette tension Vpix est supérieure au second seuil de tension V2 le signal est à nouveau incrémenté d'une ou deux unités jusqu'à ce que la tension Vpix soit bien localisée par rapport à la gamme dynamique.

Bien entendu, les valeurs du signal de commande S_HL indiquées ci-dessus sont données à titre d'exemple car elles peuvent être agencées différemment pour sélectionner un des seuils de tension à comparer avec la tension Vpix.

Une fois que la tension Vpix a été située dans une des zones d'illumination, le mot binaire à 2 bits de poids fort fourni par le premier convertisseur est défini par la valeur du signal de commande S_HL. Ce mot binaire à 2 bits permet de configurer le second convertisseur 22 pour qu'il travaille dans la plage de tension sélectionnée où se trouve la tension Vpix.

Le second convertisseur 22 comprend notamment un multiplexeur 23 de tension inférieure Vinf, qui reçoit en entrée la tension basse V0 de la gamme dynamique et les trois seuils de tension V1 à V3. Ce multiplexeur est commandé par le même signal de commande S_HL de manière à fournir en sortie la tension inférieure Vinf. Ainsi en fonction du mot binaire du premier convertisseur relatif à la valeur du signal de commande S_HL, le second convertisseur est configuré pour opérer entre la tension supérieure fournie par le multiplexeur 24 et la tension inférieure fournie par le multiplexeur 23. En fonction de ces tensions inférieure et supérieure de la plage de tension sélectionnée, des moyens d'adaptation de conversion du second convertisseur permettent à ce dernier de convertir le signal de tension du pixel sur un nombre de bits inférieur ou égal à M. Comme le second convertisseur 22 fournit un mot binaire à 8 bits LSB, les moyens d'adaptation permettent au second convertisseur d'opérer une conversion sur 8 bits pour une première zone de faible illumination, sur 7 bits pour une seconde zone de moyenne illumination et sur 6 bits pour des troisième et quatrième zones de forte illumination. Les bits non convertis par le second convertisseur sont définis arbitrairement de manière à ce que le dispositif 1 fournisse un mot binaire à 10 bits.

Comme pour une zone faiblement éclairée, il est nécessaire que le second convertisseur convertisse plus finement qu'en moyenne ou en forte illumination, la taille des plages de tension varie. Cette variation de taille des plages de tension permet de modifier le gain de conversion. Cette taille est plus petite pour une zone faiblement éclairée que pour une zone fortement éclairée afin de tenir compte de la différence de bruit entre ces deux zones.

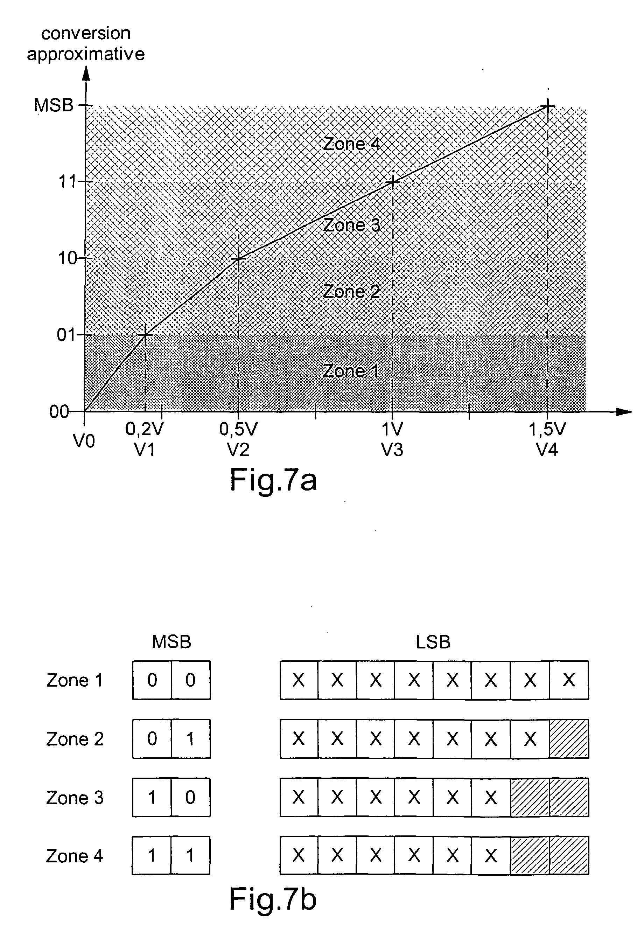

Comme montré à la figure 7a, la taille de la première plage de tension de la gamme dynamique, correspondant à la première zone d'illumination Zone 1 des pixels faiblement éclairés, est proche de 0,2 V. La taille de la seconde plage de tension, correspondant à la seconde zone d'illumination Zone 2 des pixels moyennement éclairés, est d'environ 0,3 V. Finalement, la taille des troisième et quatrième plages de tension, correspondant aux troisième et quatrième zones d'illumination Zone 3 et Zone 4 des pixels fortement éclairés, est de 0,5 V chacune. Chaque zone d'illumination correspond à un mot binaire différent fourni par le premier convertisseur.

A ce titre pour les plages de tension, on peut définir un gain de conversion ou une sensibilité par bit de conversion par les formules suivantes :

$$\text{gain} : A_{conv} = (2^n)/\Delta V_{zone} \qquad \text{sensibilité} : S_{conv} = \Delta V_{zone}/(2^n) \ [mV]$$

où $\Delta V_{zone}$ est la taille de la plage de tension correspondante et n définit le nombre de bits de conversion du second convertisseur. Pour une conversion dans la première plage de tension, la sensibilité par bit de conversion est proche de 0,8 mV, car le second convertisseur opère une conversion sur 8 bits. Grâce à la taille adaptée de cette première plage de tension, la précision de conversion peut être considérée équivalente à celle d'un convertisseur linéaire à 11 bits opérant sur toute la gamme dynamique. Pour une conversion dans la seconde plage de tension, la sensibilité par bit de conversion est légèrement supérieure à 2 mV, car le second convertisseur n'opère une conversion que sur 7 bits. Finalement, pour une conversion dans les troisième et quatrième plages de tension, la sensibilité par bit de conversion est proche de 7,8 mV, car le second convertisseur n'opère une conversion que sur 6 bits.

Ainsi, avec ces tailles différentes des plages de tension, il est possible de réaliser une amplification 8 fois plus importante pour les signaux de tension des pixels faiblement éclairés par rapport aux signaux des pixels fortement éclairés. De ce fait, le dispositif de conversion analogique-numérique surnuméraire est configuré pour éviter de convertir inutilement du bruit et effectuer une conversion avec un nombre minimum d'étapes.

A la figure 7b, il est représenté un registre à 10 bits pour chaque mot binaire de pixels qui se trouvent soit dans la zone 1, dans la zone 2, dans la zone 3 ou dans la zone 4. Les deux bits de poids fort MSB sont calculés par le premier convertisseur pour situer chaque pixel dans une des plages de tension déterminée, alors que les 8 bits de poids faible LSB sont définis par le second convertisseur. Dans la zone 1, le second convertisseur convertit le signal de tension du pixel faiblement éclairé sur 8 bits. Dans la zone 2, le second convertisseur ne convertit le signal de tension du pixel moyennement éclairé que sur 7 bits sans convertir le dernier bit de poids faible qui est noyé dans le bruit et ne représente donc aucune information. Dans les zones 3 et 4, le second convertisseur ne convertit le signal de tension du pixel fortement éclairé que sur 6 bits sans convertir les deux derniers bits de poids faible ne correspondant qu'à du bruit.

De manière plus détaillée, la figure 5 montre les composants du dispositif de conversion analogique-numérique surnuméraire combinant les premier et second convertisseurs. Comme expliqué également ci-dessous en référence à la figure 8 relative au procédé de conversion, le premier convertisseur doit situer, dans une première phase et de manière successive, la tension du pixel Vpix dans une des plages de tension. Pour ce faire, le dé-multiplexeur 31 est commandé par un signal de commande S_in de manière à fournir en sortie désignée 1 le signal de tension Vpix. Ce signal de commande S_in est produit par un générateur de signaux de commande 37. Le multiplexeur 32 reçoit à l'entrée désignée 1 la tension Vpix. En fonction de l'état d'un signal de commande S_comp produit par le générateur de signaux de commande 37, ce multiplexeur 32 relie la tension Vpix à l'entrée positive d'un unique comparateur 33 représentant les moyens de comparaison.

Dans cette première phase, une comparaison doit être réalisée entre la tension Vpix et un des seuils de tensions V1 à V3 fourni par le multiplexeur 24 de tension supérieure. Le seuil de tension sélectionné par le signal de commande S_HL décrit précédemment passe par un dé-multiplexeur 34 qui est commandé également par le signal de commande S_in pour fournir en sortie désignée 1 le seuil de tension sélectionné. Initialement, le premier seuil de tension est sélectionné pour être relié à l'entrée négative du comparateur 33. Si la tension Vpix est supérieure à ce premier seuil de tension V1, le signal de sortie Comp_res du comparateur va commander le générateur de signaux 37 pour qu'il incrémente d'une unité le signal de commande S_HL. Ainsi, une comparaison entre la tension Vpix et un seuil de tension déterminé va se poursuivre jusqu'à pouvoir situer la tension Vpix dans une des plages de tension de la gamme dynamique. Si à la fin de l'étape de comparaison, le signal de commande S_HL vaut 00 en binaire, la tension Vpix est dans la première plage de tension. Si le signal S_HL vaut 01 en binaire, la tension Vpix est dans la seconde plage de tension. Si le signal S_HL vaut 10 en binaire, la tension Vpix est dans la troisième plage de tension. Finalement, si le signal S_HL vaut 11 en biniare, la tension Vpix est dans la quatrième plage de tension.

Après que les deux bits de poids fort MSB ont été déterminés, le second convertisseur doit pouvoir opérer une conversion fine en fonction de la plage de tension déterminée. Pour ce faire, le second convertisseur comprend notamment un circuit de commutation 35 ayant des moyens d'adaptation de conversion selon la plage de tension déterminée et un réseau à capacités commutées 36, qui sont montrés à l'intérieur du cadre en traits interrompus.

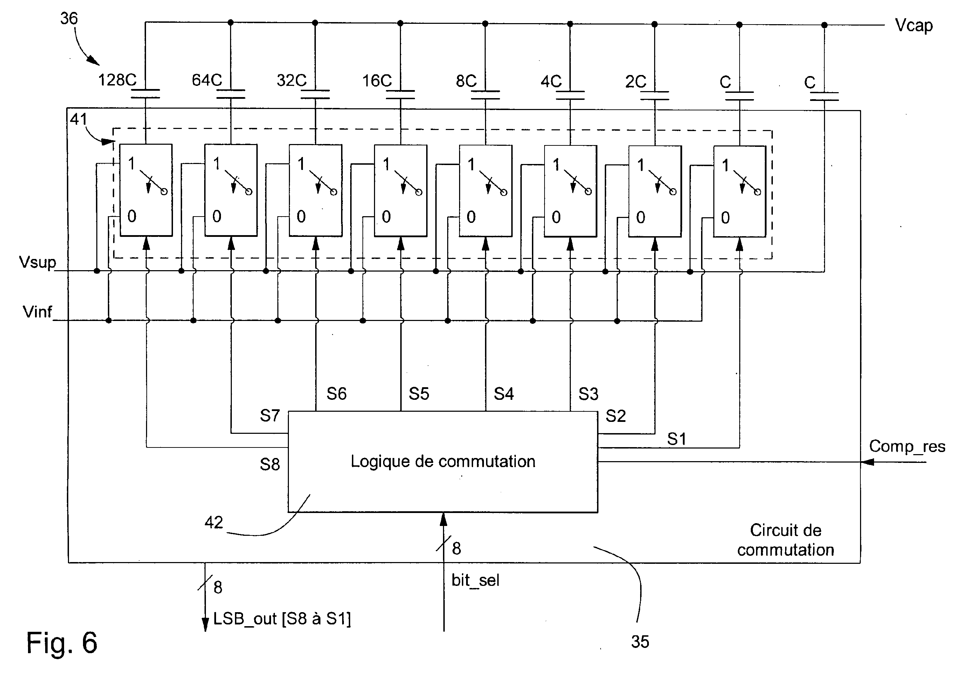

Pour les opérations de conversion, le circuit de commutation 35 reçoit notamment une tension haute Vsup fournie par le multiplexeur 24 et une tension basse Vinf fournie par le multiplexeur 23 selon la plage de tension déterminée. Le circuit de commutation, qui est expliqué ci-dessous de manière plus détaillée en référence à la figure 6, commande la connexion successive de 8 capacités de valeurs pondérées par puissance de 2 à la tension inférieure Vinf ou à la tension supérieure Vsup en fonction du niveau de la tension du pixel Vpix.

Une borne Vcap du réseau à capacités commutées 36 est commune à toutes les capacités du réseau. Cette borne Vcap est reliée à la borne positive du comparateur 33 lorsque l'entrée désignée 0 du multiplexeur 32 est sélectionnée par le signal de commande S_comp. De cette manière, le comparateur 33 du premier convertisseur peut avantageusement être réutilisé dans les opérations de conversion du second convertisseur.

La conversion fine commence par une phase de charge où la borne Vcap est tout d'abord reliée à la tension haute fournie par le multiplexeur 24 lorsque la sortie désignée 0 est sélectionnée par le signal de commande S_in. Ce signal de commande S_in permet également au dé-multiplexeur 31 de fournir à sa sortie désignée 0, la tension du pixel Vpix. Cette tension du pixel Vpix remplace dans la phase de charge du réseau de capacités la tension Vsup à l'entrée du circuit de commutation 35.

Après cette étape de charge, la borne Vcap est laissée flottante et est décalée d'une tension équivalente à la tension du pixel Vpix lorsque le dé-multiplexeur 34 est commuté sur la sortie désignée 1. De cette manière à l'aide d'un signal de sélection à 8 bits bit_sel fourni par le générateur de signaux de commande 37, l'opération de conversion fine par le second convertisseur peut être réalisée. Les capacités du réseau 36 sont connectées successivement à la tension inférieure Vinf, puis reconnectée à la tension supérieure Vsup en fonction du signal de sortie Comp_res du comparateur 33. Comme cette opération de conversion à l'aide d'un réseau à capacités commutées est bien connue, il n'est décrit que sommairement les éléments constituant ce second convertisseur.

La figure 6 montre de manière plus détaillée les principaux composants du second convertisseur. Le circuit de commutation 35 comprend une logique de commutation 42 pour commander un groupe de multiplexeurs 41, montré dans un cadre en traits interrompus. La sortie de chaque multiplexeur du groupe de multiplexeurs 41 est reliée à une des huit capacités du réseau commuté 36. La valeur de chaque capacité est dépendante de la position de chaque bit de conversion dans un mot binaire déterminé par le second convertisseur, c'est-à-dire dépendante d'une puissance de 2. De ce fait, les valeurs des capacités sont définies du bit le plus faible au bit le plus fort de la valeur C à la valeur 128C. Une capacité supplémentaire C doit être prévue dans le second convertisseur, dont une borne est reliée au noeud flottant Vcap et l'autre borne doit être reliée à un potentiel fixe quelconque par exemple à Vsup.

Une entrée désignée 1 des multiplexeurs est reliée à la tension supérieure Vsup, alors qu'une entrée désignée 0 est reliée à la tension inférieure Vinf de la plage de tension déterminée. Dans cette logique de commutation, qui reçoit le signal de sélection à 8 bits bit_sel et le signal de sortie Comp_res du comparateur, des signaux de commutation S1 à S8 sont déterminés afin de commander successivement chacun un multiplexeur correspondant du groupe de multiplexeurs 41. Cette logique de commutation 35 va commuter successivement chaque capacité à la tension inférieure Vinf, puis la rétablir à la tension supérieure Vsup en fonction du signal Comp_res de la comparaison. Cette opération s'effectue en partant de la capacité de plus grande valeur à la capacité la plus faible.

Suivant la plage de tension déterminée, le circuit de commutation avec la logique de commutation est configuré pour exécuter des opérations de conversion sur 8 bits en cas de faible illumination, sur 7 bits en cas de moyenne illumination ou sur 6 bits en cas de forte illumination. A la fin de la seconde conversion, l'état des signaux de commutation S1 à S8 vont servir à fournir le mot binaire à 8 bits LSB_out qui est placé dans un registre du dispositif en tant que bits de poids faible. Bien entendu, selon la zone d'illumination déterminée, le ou les deux derniers bits de ce mot binaire sont définis arbitrairement.

Les étapes du procédé de conversion analogique-numérique vont être décrites ci-dessous en référence à la figure 8. Le tableau suivant montre l'état des différents signaux de commande représentés à la figure 5 qui sont appliqués aux multiplexeurs respectifs selon les différentes étapes du procédé :

| PHASES | S_in | S_comp | S_HL |
|---|---|---|---|
| Pré-charge | 1 | 1 | 00 |
| 1 ère conversion | 1 | 1 | 00, 01, 10, 11 |
| Charge | 0 | 0 | Sélection |
| 2e conversion | 1 | 0 | Sélection |

La première étape 50 du procédé de conversion analogique-numérique est relative à une phase de pré-charge dans laquelle le pixel fournit une tension relative à son illumination au dispositif de conversion analogique-numérique. Dès le moment où le dispositif de conversion reçoit une valeur stable de la tension du pixel, le premier convertisseur est mis en fonction pour opérer une conversion grossière.

A l'étape 51, la tension du pixel Vpix est comparée au premier seuil de tension V1. Si cette tension Vpix est inférieure au seuil V1, alors le pixel est faiblement éclairé et la première plage de tension de la gamme dynamique est sélectionnée par le mot binaire à 2 bits de poids fort MSB valant 00 à l'étape 52. Par contre si cette tension Vpix est supérieure à V1, alors le signal S_HL est incrémenté d'une unité afin de permettre la comparaison de la tension Vpix avec le second seuil de tension V2 à l'étape 53. Si la tension Vpix est inférieure au seuil V2, alors la seconde plage de tension de la gamme dynamique est sélectionnée par le mot binaire à 2 bits de poids fort MSB valant 01 à l'étape 54. Par contre si cette tension Vpix est supérieure à V2, alors le signal S_HL est incrémenté d'une unité afin de permettre la comparaison de la tension Vpix avec le troisième seuil de tension V3 à l'étape 55. Si la tension Vpix est inférieure au seuil V3, alors la troisième plage de tension de la gamme dynamique est sélectionnée par le mot binaire à 2 bits de poids fort MSB valant 10 à l'étape 56. Par contre si cette tension Vpix est supérieure au troisième seuil de tension V3, alors le pixel se trouve dans la zone de plus forte illumination. Le signal S_HL est ainsi incrémenté d'une unité afin que la quatrième plage de tension de la gamme dynamique soit sélectionnée par le mot binaire à 2 bits de poids fort MSB valant 11 à l'étape 57.

En relation avec le mot binaire à 2 bits fourni par le premier convertisseur, un nombre minimal $n_{min}$ est défini pour arrêter le second convertisseur avant qu'il ne convertisse du bruit.

Avant d'entreprendre les étapes de la conversion fine, une phase de charge des condensateurs du réseau à capacités commutées est réalisée à l'étape 58 de manière à échantillonner la tension Vpix. Comme on peut le voir par le tableau ci-dessus dans cette phase de charge à l'étape 58, les signaux S_in et S_comp sont à l'état 0. Ceci signifie que la borne commune des capacités Vcap reçoit la tension haute de la plage de tension déterminée, alors que le circuit de commutation et la borne négative du comparateur reçoivent la tension du pixel en lieu et place de la tension haute. Le réseau de capacités est alors chargé à Vsup-Vpix.

Après avoir chargé cette borne commune des capacités, le signal de commande S_in passe à l'état 1 ce qui laisse cette borne commune flottante. Le circuit de commutation reçoit à nouveau la tension haute Vsup de la plage de tension déterminée. Ceci a pour conséquence d'élever le niveau de tension de la borne commune des capacités de la tension Vsup, on a alors la tension Vcap=(2Vsup - Vpix).

Pour la conversion fine réalisée par le second convertisseur, le nombre n de bits de conversion est fixé à 8 à l'étape 59. A l'étape 60 dans le circuit logique, le multiplexeur de la capacité représentant le bit numéro 8 (128C) est commuté de la tension Vsup à la tension Vinf. Un contrôle de la tension Vcap est effectué à l'étape 61 afin de savoir si cette tension Vcap est passée en dessous de la tension Vsup. Dans l'affirmative, le multiplexeur de la capacité représentant le bit numéro 8 est commuté de la tension Vinf à la tension Vsup à l'étape 62, avant d'opérer le contrôle de fin de conversion à l'étape 63. Par contre si la tension Vcap est supérieure à la tension Vsup à l'étape 61, le multiplexeur reste en l'état. Si le nombre n est inférieur ou égal au nombre minimal $n_{min}$, la conversion fine est terminée. Dans le cas contraire, le nombre n est décrémenté d'une unité et les étapes 60 à 63 sont exécutées relatives à la connexion de la capacité représentant le bit numéro 7 (64C). Toutes les étapes 60 à 64 sont effectuées successivement pour la connexion des autres capacités à la tension Vinf ou à la tension Vsup jusqu'à ce que n soit inférieur ou égal à $n_{min}$.

Au terme de la conversion fine, le second convertisseur fournit un mot binaire à 8 bits de poids faible, après avoir effectué une conversion de 6 à 8 bits en fonction de la plage de tension déterminée du pixel. Le ou les bits de poids faible non convertis par le second convertisseur sont fixés de manière arbitraire. Avec ce procédé de conversion analogique-numérique, il est à noter que le nombre de comparaisons effectuées par le comparateur, soit le total de la conversion grossière et de la conversion fine, est toujours identique, indépendamment de l'illumination du pixel. Grâce au procédé de mise en action du dispositif de conversion analogique-numérique, il est effectué 9 comparaisons pour n'importe quelle zone d'illumination du pixel. Ainsi, le dispositif de conversion permet de fournir une précision suffisante à faible illumination tout en évitant de convertir inutilement du bruit à moyenne ou forte illumination.

A partir de la description qui vient d'être faite de multiples variantes de réalisation du dispositif et du procédé de conversion analogique-numérique peuvent être conçues par l'homme du métier sans sortir du cadre de l'invention définie par les revendications. Dans le cas d'un dispositif fournissant un mot binaire à 10 bits, il peut être prévu par exemple que le premier convertisseur fournisse un mot binaire à 1 bit, à 3 bits ou à 4 bits, alors que le second convertisseur fournit un mot binaire à 9 bits, 7 bits ou à 6 bits. Bien entendu, le nombre de zones d'illumination est dépendant du nombre de bits fourni par le premier convertisseur. En lieu et place d'un unique comparateur, il peut être prévu que les moyens de comparaison comprennent plusieurs comparateurs placés en parallèle pour comparer en même temps chaque seuil de tension avec la tension du pixel.

## Revendications

1. Dispositif de conversion analogique-numérique (1) notamment pour un capteur d'image (11) qui comprend une cellule photosensible à matrice de pixels (2) pour capter une image à numériser, le dispositif comprenant au moins un premier convertisseur à N bits (21) recevant un signal de tension (Vpix) ou de courant d'un pixel, dont le niveau de tension ou de courant est dépendant de la lumière captée par le pixel dans une gamme dynamique (Vdyn) déterminée de tension ou de courant du capteur, et au moins un second convertisseur à M bits (22) connecté au premier convertisseur, les premier et second convertisseurs permettant de convertir le niveau de tension ou de courant du pixel sur N+M bits, **caractérisé en ce que** le premier convertisseur (21) comprend des moyens de comparaison (33) pour comparer le niveau de tension ou de courant du pixel avec un ou plusieurs seuils de tension (V0 à V4) ou de courant délimitant des plages de tension ou de courant dans la gamme dynamique déterminée, lesdites plages successives de tension ou de courant pouvant représenter des zones d'illumination du pixel entre une zone faiblement éclairée et une zone fortement éclairée, ledit premier convertisseur fournissant un mot binaire à N bits relatif à la zone déterminée d'illumination du pixel, et **en ce que** le second convertisseur comprend des moyens d'adaptation de conversion (35) pour convertir le signal de tension ou de courant du pixel sur un nombre de bits inférieur ou égal à M dépendant du mot binaire à N bits du premier convertisseur.

2. Dispositif de conversion selon la revendication 1, **caractérisé en ce qu'**il comprend un registre dans lequel sont placés les N bits de poids fort du premier convertisseur non linéaire et les M bits de poids faible du second convertisseur linéaire.

3. Dispositif de conversion selon l'une des revendications précédentes, **caractérisé en ce que** le premier convertisseur fournit un mot binaire à 2 bits de poids fort pour définir 4 zones d'illumination déterminées par les plages de tension correspondantes de la gamme dynamique de tension, et **en ce que** les moyens d'adaptation de conversion du second convertisseur permettent au second convertisseur d'exécuter une conversion sur 8 bits dans le cas où le niveau de tension du pixel se trouve dans une première plage de tension représentant une zone faiblement éclairée, une conversion sur 7 bits dans le cas où le niveau de tension du pixel se trouve dans une deuxième plage de tension représentant une zone d'illumination moyenne, et une conversion sur 6 bits dans le cas où le niveau de tension du pixel se trouve dans des troisième ou quatrième plages de tension représentant des zones de forte illumination, les bits de poids faible non convertis par le second convertisseur étant définis arbitrairement de manière que les premier et second convertisseurs fournissent un mot binaire à 10 bits.

4. Dispositif de conversion selon l'une des revendications précédentes, **caractérisé en ce qu'**il est configuré pour que la taille de chaque plage de tension ou de courant de la gamme dynamique soit dépendante d'un facteur de bruit du capteur, la taille de la plage de tension représentant une zone faiblement éclairée étant plus petite que la taille de la plage de tension représentant une zone moyennement ou fortement éclairée de manière à augmenter la sensibilité par bit pour les opérations de conversion du second convertisseur.

5. Dispositif de conversion selon la revendication 4, **caractérisé en ce que** la taille de la première plage de tension pour une zone faiblement éclairée est définie de telle manière que la sensibilité par bit de conversion du second convertisseur corresponde à une sensibilité par bit équivalente d'un convertisseur linéaire traditionnel à N+M+1 bits, notamment d'un convertisseur à 11 bits sur toute la gamme dynamique de tension ou de courant, et **en ce que** la taille de la dernière plage de tension pour une zone fortement éclairée est définie de telle manière que la sensibilité par bit de conversion du second convertisseur corresponde à une sensibilité par bit sensiblement équivalente d'un convertisseur linéaire traditionnel à N+M-2 bits, notamment d'un convertisseur à 8 bits sur toute la gamme dynamique de tension ou de courant pour tenir compte d'un facteur de bruit 8 fois plus fort dans la zone fortement éclairée que dans la zone faiblement éclairée.

**6.** Dispositif de conversion selon la revendication 1, **caractérisé en ce que** le premier convertisseur comprend un dé-multiplexeur (31) commandé par un premier signal de commande (S_in) fourni par un générateur de signaux de commande pour relier le signal de tension (Vpix) ou de courant d'un pixel à une première entrée des moyens de comparaison, tel qu'un comparateur (33), ou à une première entrée d'un circuit de commutation (35) du second convertisseur dans une phase de charge, un premier multiplexeur (24) recevant en entrée les seuils de tension ou de courant délimitant les plages de tension ou de courant et la valeur limite haute de tension ou de courant de la gamme dynamique, le premier multiplexeur étant commandé par un second signal de commande (S_HL) fourni par ledit générateur de signaux de commande (37) pour connecter un des seuils de tension ou de courant à une seconde entrée du comparateur, la sortie du comparateur étant connectée au générateur de signaux de commande pour modifier ou conserver l'état du second signal de commande en fonction du résultat de la comparaison entre le signal de tension ou de courant du pixel avec un des niveaux seuils de tension ou de courant.

**7.** Dispositif de conversion selon la revendication 6, **caractérisé en ce que** le second convertisseur comprend un réseau à capacités commutées (36), le circuit de commutation (35) pour commander la connexion de capacités dudit réseau, et un second multiplexeur (23) commandé par le second signal de commande (S_HL) fourni par ledit générateur de signaux de commande (37), ledit second multiplexeur recevant en entrée la valeur limite basse de tension ou de courant de la gamme dynamique, et les seuils de tension ou de courant pour fournir une tension inférieure de la plage de tension déterminée à une seconde entrée du circuit logique dépendant du mot binaire fourni par le premier convertisseur, le mot binaire étant défini par l'état du second signal de commande à N bits, de préférence à 2 bits, la première entrée du circuit logique recevant une tension supérieure de la plage de tension déterminée fournie par le premier multiplexeur.

**8.** Dispositif de conversion selon la revendication 7, **caractérisé en ce que** le second convertisseur comprend un troisième multiplexeur (32) relié entre le dé-multiplexeur et le comparateur, le troisième multiplexeur étant commandé par un troisième signal de commande (S_comp) fourni par le générateur de signaux de commande de manière à connecter une borne du réseau à capacités commutées au comparateur du premier convertisseur dans une phase de conversion du second convertisseur, et **en ce que** le second convertisseur opère entre les tensions inférieure et supérieure de la plage de tension déterminée par le mot binaire fourni par le premier convertisseur pour convertir le niveau de tension ou de courant sur un nombre de bits inférieur ou égal à M.

**9.** Capteur d'image comprenant une cellule photosensible à matrice de pixels (2) pour capter une image à numériser, au moins un dispositif de conversion analogique-numérique selon l'une des revendications précédentes, un moyenneur d'illumination (5) relié en sortie du dispositif, et un adaptateur d'échelle (4) relié en sortie du dispositif et recevant un signal de commande du moyenneur, **caractérisé en ce que** le dispositif comprend plusieurs premier et second convertisseurs placés en parallèle de manière à convertir chacun sur N+M bits un signal de tension ou de courant fourni par un pixel correspondant, et **en ce que** le moyenneur reçoit le résultat de la conversion du niveau de tension ou de courant de chaque pixel pour fournir un signal de commande à l'adaptateur afin qu'il fournisse en sortie un mot binaire à M bits sélectionnés dans chaque mot binaire à N+M bits fournis par le dispositif en fonction de la zone moyenne d'illumination déterminée par ledit moyenneur.

**10.** Capteur d'image selon la revendication 9, **caractérisé en ce que** le dispositif de conversion fournit un mot binaire à 10 bits relatif au niveau de tension ou de courant de chaque pixel, et **en ce que** l'adaptateur d'échelle sélectionne 8 bits successifs de chaque mot binaire à 10 bits en fonction de la zone moyenne d'illumination déterminée par ledit moyenneur.

**11.** Procédé de conversion analogique-numérique, notamment d'un capteur d'image (11) qui comprend une cellule photosensible à matrice de pixels (2) pour capter une image à numériser, pour la mise en action du dispositif de conversion selon l'une des revendications 1 à 8, **caractérisé en ce qu'**il comprend une série d'étapes consistant à :

- comparer dans le premier convertisseur le niveau de tension ou de courant du pixel avec au moins un seuil de tension ou de courant de la gamme dynamique délimitant des plages de tension ou de courant représentant des zones d'illumination entre une zone faiblement éclairée et une zone fortement éclairée,
- fournir un mot binaire à N bits relatif à la zone d'illumination déterminée du pixel,
- adapter le second convertisseur en fonction du mot binaire à N bits du premier convertisseur,
- convertir dans le second convertisseur le niveau de tension ou de courant du pixel sur un nombre de bits inférieur ou égal à M en fonction du mot binaire à N bits du premier convertisseur.

**12.** Procédé de conversion selon la revendication 10, **caractérisé en ce que** le premier convertisseur fournit un mot binaire à 2 bits de poids fort pour définir 4 zones d'illumination déterminées par les plages de tension correspondantes de la gamme dynamique de tension, la taille de la première plage de tension de la zone faiblement éclairée étant plus petite que la taille des plages de tension des zones moyennement ou fortement éclairées, et **en ce que** le second convertisseur exécute une conversion sur 8 bits dans le cas où le niveau de tension du pixel se trouve dans une première plage de tension représentant une zone faiblement éclairée, une conversion sur 7 bits dans le cas où le niveau de tension du pixel se trouve dans une deuxième plage de tension représentant une zone d'illumination moyenne, et une conversion sur 6 bits dans le cas où le niveau de tension du pixel se trouve dans des troisième ou quatrième plages de tension représentant des zones de forte illumination, les bits de poids faible non convertis par le second convertisseur étant définis arbitrairement pour que le dispositif fournisse un mot binaire à 10 bits.

Fig.1a
(art antérieur)

Fig.1b
(art antérieur)

Fig.2

Fig.3

Fig.4

Fig.5

Fig. 6

Fig.7a

Fig.7b

50 — Sample & Hold

Phase de précharge

- - - - - - - - - - - - - - - - - - - - - - - - - -

51 — Vpix<V1 → **Vrai** → 52 — MSB=00 — $n_{min}=1$

↓ **Faux**

53 — Vpix<V2 → **Vrai** → 54 — MSB=01 — $n_{min}=2$

↓ **Faux**

55 — Vpix<V3 → **Vrai** → 56 — MSB=10 — $n_{min}=3$

↓ **Faux**

57 — MSB=11 — $n_{min}=3$

Conversion grossière

- - - - - - - - - - - - - - - - - - - - - - - - - -

58 — Charge capacités

Phase de charge

- - - - - - - - - - - - - - - - - - - - - - - - - -

59 — n=8

Conversion fine

60 — Commuter bit #n de Vsup à Vinf → 61 — Vcap<Vsup → **Faux**

↓ **Vrai**

62 — Commuter bit #n de Vinf à Vsup

64 — n = n-1

63 — $n \leq n_{min}$ Conversion finie? → **Faux**

↓ **Vrai**

Fig.8

17

**Office européen des brevets**

**RAPPORT DE RECHERCHE EUROPEENNE**

Numéro de la demande

EP 03 01 2594

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 4 733 217 A (DINGWALL ANDREW G F) 22 mars 1988 (1988-03-22) * colonne 2, ligne 16 - ligne 30 * * colonne 3, ligne 47 - colonne 5, ligne 43 * * figure 1 * --- | 1,11 | H04N5/235 H04N5/335 H03M1/18 |
| A | US 2002/140842 A1 (OLDING BENJAMIN P ET AL) 3 octobre 2002 (2002-10-03) * alinéa [0042] - alinéa [0048] * * alinéa [0053] * --- | 1,11 | |
| A | EP 0 567 145 A (MATSUSHITA ELECTRIC IND CO LTD) 27 octobre 1993 (1993-10-27) * page 3, ligne 23 - ligne 52 * * page 4, ligne 20 - ligne 40 * * page 5, ligne 29 - page 6, ligne 21 * * figures 4,7 * ----- | 1,11 | |

|  |  |  | DOMAINES TECHNIQUES RECHERCHES (Int.Cl.7) |
|---|---|---|---|
|  |  |  | H04N H03M |

Le présent rapport a été établi pour toutes les revendications

| Lieu de la recherche | Date d'achèvement de la recherche | Examinateur |
|---|---|---|
| LA HAYE | 3 octobre 2003 | Didierlaurent, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03 82 (P04C02)

## ANNEXE AU RAPPORT DE RECHERCHE EUROPEENNE
## RELATIF A LA DEMANDE DE BREVET EUROPEEN NO.

EP 03 01 2594

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-10-2003

| Document brevet cité au rapport de recherche | | Date de publication | Membre(s) de la famille de brevet(s) | | Date de publication |
|---|---|---|---|---|---|
| US 4733217 | A | 22-03-1988 | CA | 1269459 A1 | 22-05-1990 |
| | | | DE | 3715237 A1 | 12-11-1987 |
| | | | FR | 2598571 A1 | 13-11-1987 |
| | | | GB | 2190258 A ,B | 11-11-1987 |
| | | | HK | 2795 A | 13-01-1995 |
| | | | JP | 2589982 B2 | 12-03-1997 |
| | | | JP | 62285522 A | 11-12-1987 |
| | | | KR | 9513873 B1 | 17-11-1995 |
| | | | SG | 25192 G | 15-05-1992 |
| US 2002140842 | A1 | 03-10-2002 | AUCUN | | |
| EP 0567145 | A | 27-10-1993 | US | 5231398 A | 27-07-1993 |
| | | | DE | 69325610 D1 | 19-08-1999 |
| | | | DE | 69325610 T2 | 13-04-2000 |
| | | | EP | 0567145 A2 | 27-10-1993 |
| | | | JP | 6029847 A | 04-02-1994 |

EPO FORM P0460

Pour tout renseignement concernant cette annexe : voir Journal Officiel de l'Office européen des brevets, No.12/82